# EUROPEAN PATENT APPLICATION

(11) **EP 1 304 732 A1**
(43) Date of publication of application: **23.04.2003**
(21) Application number: 01123261.8
(22) Date of filing: 02.10.2001
(51) Int. Cl.: H01L 21/3213

(54) **Method for structuring a metal containing layer of a semiconductor device**

(71) Applicant: Infineon Technologies AG, 81669 München (DE)
(72) Inventor: Weber, Detlef, Dr., 01458 Grünberg (DE); Bachmann, Jens, 01109 Dresden (DE)
(74) Representative: Epping Hermann & Fischer

(57) **Abstract**

A carbon containing isolating layer (20) is formed on a substrate (5). A conductive, metal containing layer (25) is formed on the carbon containing isolating layer (20) and a hard mask layer (30) is formed on the conductive, metal containing layer (25). A photo resist (35) is arranged on the hard mask layer (30) and structured. The hard mask layer (30) is structured while using the structured photo resist (35) as an etch mask. The photo resist (35) is removed and the conductive, metal containing layer (25) is structured with the hard mask layer (30) as an etch mask.

## Description

The invention relates to a method for structuring a metal containing layer of a semiconductor device.

In the field of semiconductor manufacturing, it is known to form conducting, metal containing layers in order to connect different components of the device. Aluminium and aluminium alloys are often used to form metal lines in integrated circuits. To reduce the capacitive coupling between neighbouring conducting wires, it is known to use materials with a low dielectric constant (low-k) for isolating wires from each other. Typically, low-k dielectric materials comprise carbon. In order to structure the metal containing layer the layer is coated with an anti reflective layer and a photo resist. After the metal containing layer has been etched the photo resist and anti reflective coatings are to be removed. The process for removing these layers normally include treatment with oxygen. The oxygen based processes can damage the underlying carbon containing low-k dielectric.

It is an objective of the present invention to provide a method for structuring a conductive, metal containing layer which is arranged on a carbon containing isolating layer having a low dielectric constant.

This objective is solved by a method for structuring a metal containing layer comprising the following steps:
- providing a substrate having a carbon containing isolating layer arranged on the substrate;
- forming the conductive, metal containing layer on the isolating layer;
- forming a hard mask layer on the conductive, metal containing layer;
- forming and structuring a photo resist layer on the hard mask layer;
- structuring the hard mask layer using the structured photo resist to obtain an etch mask;
- removing the photo resist from the hard mask layer;
- structuring the conductive, metal containing layer using the structured hard mask layer as an etch mask.

The inventive method uses a hard mask layer to structure the metal containing, conducting layer. The additional hard mask layer allows to protect the low-k dielectric layer, which is arranged under the conductive, metal containing layer. The photo resist layer is removed after structuring the hard mask layer and before structuring the conductive, metal containing layer with the hard mask layer. This protects the underlying low-k dielectric layer from damage due to photoresist removal.

According to an embodiment of the present invention, the isolating layer comprises organic polymers. Organic polymers provide an isolating layer with a low dielectric constant. The dielectric constant of the isolating layer is preferably lower than 3.5.

According to another embodiment of the present invention, the isolating layer comprises molecules of compound silicon-carbon-oxygen-hydrogen. The compounds provide a dielectric layer with a low dielectric constant.

In a preferred embodiment of the method according to the invention, the isolating layer is formed on the substrate with a spin-on technique. Spin-on techniques are well known in the art for arranging organic polymers on a substrate.

In a further embodiment of the method according to the invention, the isolating layer is formed by a chemical vapour deposition process. A chemical vapour deposition process is suitable for depositing compounds of silicon-carbon-oxygen-hydrogen (Si-C-O-H) by a conformable deposition process.

Photo resist residuals are formed during the structuring of the hard mask. The photo resist residuals are removed from the hard mask and from the conducting, metal containing layer using an additional cleaning process to remove photo resist residuals.

The hard mask remains on the structured conductive, metal containing layer. The structured hard mask is used as an additional isolating layer between conducting wires of the semiconductor device. The gaps between the hard mask material are filled with conducting wires.

According to another preferred embodiment, the hard mask contains silicon oxide or silicon oxinitride. These materials are preferred for the hard mask, because they provide selectivity against silicon etch and metal etch.

The invention will be better understood by reference to the following descriptions of embodiments of the invention taken in conjunction with the accompanying drawings. Equal references in the drawings show equal or functionally equal components.

The figures show:
- figure 1: a cross section through a substrate comprising an isolating layer, a hard mask, a conducting layer, and a structured photo resist;
- figure 2: the cross section of figure 1 with a structured hard mask;
- figure 3: the cross section of figure 2 with the photo resist removed from the structured hard mask;
- figure 4: a cross section according to figure 3 with a structured conducting metal containing layer.

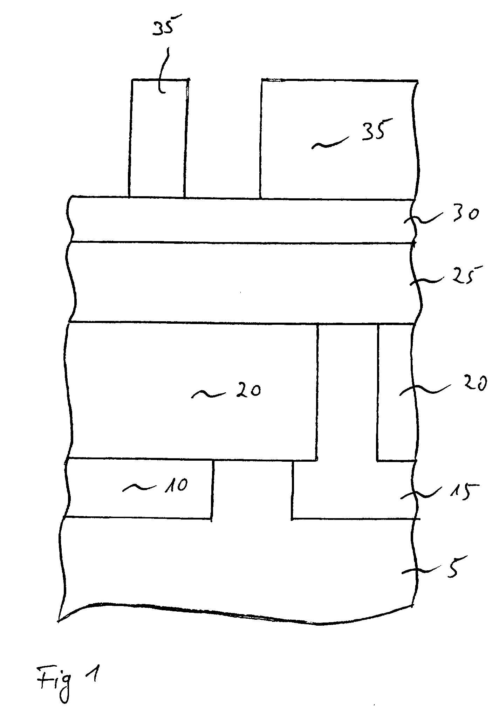

Figure 1 shows a substrate 5 having a first conducting structure 10 and a second conducting structure 15 arranged on the substrate 5. The first conductive structure 10 is separated from the second conductive structure 15 by the substrate 5. The second conductive structure 15 comprises a vertically arranged part, which functions as a contact plug.

A carbon containing isolating layer 20 is arranged on the substrate 5, the first conductive structure 10 and the second conductive structure 15. For example, the substrate 5 contains silicon or an isolating material like silicon oxide or a low-k dielectric or an electrically active devices, in particular transistors, resistors, capacitors and the like. The first conductive structure 10 and the second conductive structure 15 can comprise silicon, doped silicon, a silicide, a metal, a metal nitride or a metal alloy.

A conductive, metal containing layer 25 is formed on the carbon containing isolating layer 20 and the second conductive structure 15. The conductive metal containing layer 25 comprises silicon or a silicide or aluminium or copper or tungsten for example.

A hard mask layer 30 is arranged on the conductive, metal containing layer 25. The hard mask layer 30 comprises silicon oxide or silicon oxinitride for example. A structured photo resist 35 is arranged on the hard mask layer 30.

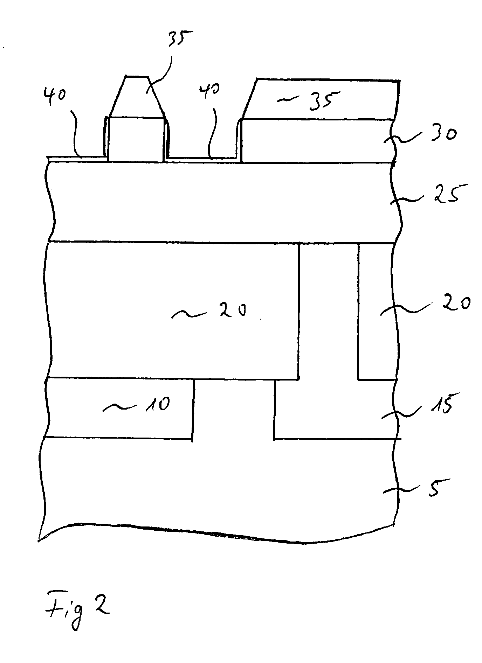

According to figure 2, the hard mask layer 30 is structured by an etching process, while the structured photo resist 35 functions as an etch mask. A structuring of the hard mask layer 30 can produce a contamination of photo resist residuals 40 on the conductive metal containing layer 25 and the hard mask layer 30. In this case, an additional cleaning step is performed to remove the structured photo resist 35 and the photo resist residuals 40 from the hard mask layer 30 and the conductive metal containing layer 25. In particular, the residuals 40 are separated from the dielectric layer 20 by the metal layer 25. When removing the polymer residuals 40 by, for example, an oxygen containing process, the dielectric layer 20 is protected by the metal layer 25. The oxygen does not damage the dielectric layer 20.

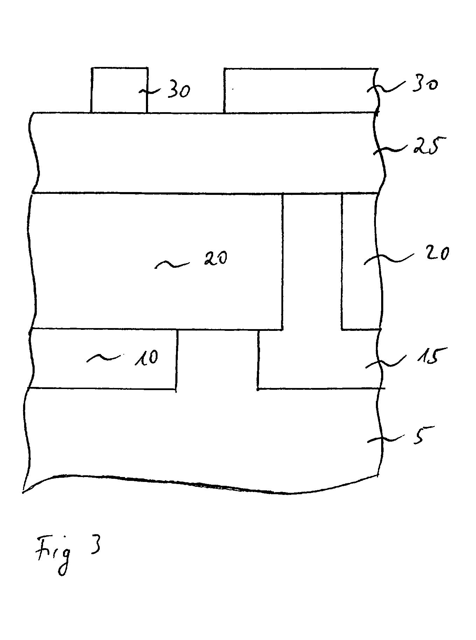

As shown in figure 3, the photo resist 35 and the photo resist residuals 40 are removed.

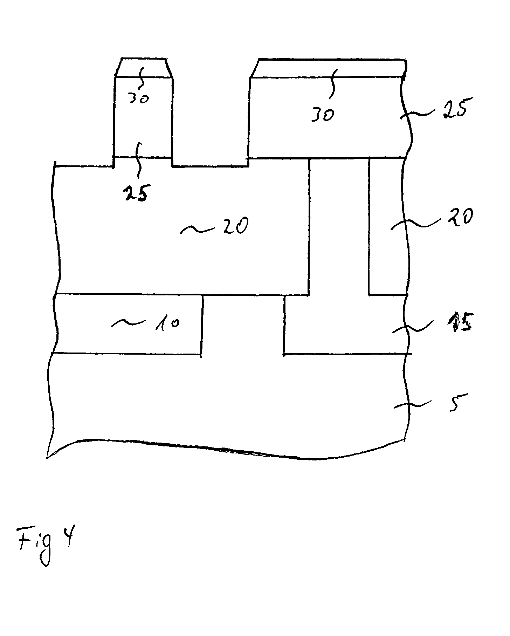

According to figure 4, the conductive, metal containing layer 25 is etched and the hard mask layer 30 functions as an etch mask for the structuring of the conductive metal containing layer 25.

## Claims

1. Method for structuring a metal containing layer (25) comprising the following steps:
- providing a substrate (5) having a carbon containing isolating layer (20) arranged on the substrate (5);
- forming the conductive metal containing layer (25) on the isolating layer (20);
- forming a hard mask layer (30) on the conductive metal containing layer (25);
- forming and structuring a photo resist layer (35) on the hard mask layer (30);
- structuring the hard mask layer (30) using the structured photo resist (35) to obtain an etch mask;
- removing the photo resist (35) from the hard mask layer (30);
- structuring the conductive metal containing layer (25) using the structured hard mask layer (30) as an etch mask.

2. Method according to claim 1,
**characterised in that**
the isolating layer (20) comprises organic polymers.

3. Method according to one of the claims 1 or 2,
**characterised in that**
the isolating layer (20) comprises compounds of silicon carbon oxygen hydrogen.

4. Method according to one of the claims 1 to 3,
**characterised in that**
the isolating layer (20) is formed on the substrate (5) by a spin-on technique.

5. Method according to one of the claims 1 to 4,
**characterised in that**
the isolating layer (20) is formed by a chemical vapour deposition process.

6. Method according to one of the claims 1 to 5,
**characterised in that**
the dielectric constant of the isolating layer (20) is lower than 3.5.

7. Method according to one of the claims 1 to 6,
**characterised in that**
photo resist residuals (40) are formed during the structuring of the hard mask (30) and the photo resist residuals (40) are removed from the hard mask (30) and the conductive metal containing layer (25) before the step of structuring the conductive metal containing layer.

8. Method according to one of the claims 1 to 7,
**characterised in that**
the hard mask (30) contains silicon oxide or silicon oxinitride.
